# EUROPEAN PATENT APPLICATION

(11) **EP 1 901 390 A1**
(43) Date of publication of application: **19.03.2008**
(21) Application number: 06767990.2
(22) Date of filing: 07.07.2006
(51) Int. Cl.: H01M 14/00, C09K 3/10, H01L 31/04, H01M 2/08

(54) **SEALING AGENT FOR PHOTOELECTRIC CONVERTER AND PHOTOELECTRIC CONVERTER USING SAME**

(30) Priority: 07.07.2005 JP 2005198217
(71) Applicant: NIPPON KAYAKU KABUSHIKI KAISHA, Tokyo 102-8172 (JP)
(72) Inventor: INOUE, Teruhisa, Functional Chemicals R & D Lab., Tokyo 115-8588 (JP); HOSHI, Takayuki, Functional Chemicals R & D Lab., Tokyo 115-8588 (JP); ASANO, Toyofumi, Functional Chemicals R & D Lab., Tokyo 115-8588 (JP); SHIGAKI,Kouichiro, Functional Chemicals R & D Lab., Tokyo 115-8588 (JP); KANEKO, Masayoshi, Functional Chemicals R & D Lab., Tokyo 115-8588 (JP); TSUCHIDA, Teppei, Functional Chemicals R & D Lab., Tokyo 115-8588 (JP)
(74) Representative: Gille Hrabal Struck Neidlein Prop Roos
(86) International application number: PCT/JP2006/313580
(87) International publication number: WO 2007/007671

(57) **Abstract**

Disclosed is a sealing agent for photoelectric converters which enables to easily bond upper and lower conductive supporting bodies during production of a photoelectric converter while forming a sealed portion having excellent adhesion strength, moisture resistance reliability, flexibility and the like. Specifically, a photocuring and thermosetting resin composition containing an epoxy resin (a), a thermosetting agent (b), an epoxy(meth)acrylate (c) and a photopolymerization initiator (d), and additionally if necessary, a filler (e), a silane coupling agent (f) and an ion capturing agent (g) is used as a sealing agent for photoelectric converters.

## Description

### TECHNICAL FIELD

The present invention relates to a sealant for a photoelectric conversion device, and a photoelectric conversion device produced by using the sealant. In particular, the present invention relates to a sealant for a photoelectric conversion device that uses both ultraviolet curing and heat curing, and a photoelectric conversion device produced by using the sealant.

### BACKGROUND ART

Solar cells, which are receiving attention as clean energy sources, have been used in general houses in recent years, but still not become widespread sufficiently. The reasons are that solar cells themselves do not have sufficient properties and have no other choice but to increase the size of modules, productivity is low in producing modules, and the like, which result in cost increase.

A photoelectric conversion device used for solar cells is typically packaged by protecting a photoelectric conversion material such as silicon, gallium-arsenic, or copper-indium-selenium by using an upper transparent protective material and a lower substrate protective material; and fixing the photoelectric conversion material and the protective materials by using a sealant. Thus the sealants used for producing photoelectric conversion devices are required to have important properties such as good adhesion to the upper and the lower protective materials, excellent flexibility, and excellent durability.

As a sealant for photoelectric conversion devices used in solar cell modules, for example, presently used is an ethylene-vinyl acetate copolymer with a high content of vinyl acetate in view of properties such as flexibility and transparency. The compound, however, does not have sufficient heat resistance and adhesion, and compounds such as organic peroxides have to be used for the purpose of accelerating the reaction. In this case, two steps have to be employed: a sheet of an ethylene-vinyl acetate copolymer containing the organic peroxides is first produced, and subsequently a photoelectric conversion material is sealed by using the sheet. In the step of producing the sheet, forming at low temperature is required so that organic peroxides do not degrade, and thus forming at high extrusion rate is impossible. On the other hand, the step of sealing (curing adhesion) a photoelectric conversion material has to be composed of a step of provisionally adhesion by using a laminator over several minutes to several tens of minutes; and a step of actual adhesion in an oven at a high temperature at which organic peroxides degrade over several tens of minutes to an hour. Therefore, there are problems that photoelectric conversion devices are produced at much expense in time and effort, and further sufficient adhesion and moisture resistance reliability are not obtained.
Solar cell modules and solar cells using such photoelectric conversion devices definitely result in high prices and insufficient properties.

Combined use of the copolymer and an ionomer having a low melting point is not preferable because thus obtained compound has insufficient heat resistance and use of the compound as a sealing material for photoelectric conversion devices can result in deformation of solar cells using the elements due to temperature increase of the solar cells in use; and when photoelectric conversion devices are produced by a thermal contact bonding method, the sealing materials can outflow excessively and form burrs. In addition, as the sizes of photoelectric conversion devices have increased in recent years, stresses applied to sealed portions on fabrication processes have increased considerably when compared to before, and sealing lengths have increased. Accordingly, there is a desire to develop a sealant to be applied that is excellent in moisture resistance reliability, enables narrowing of sealing line width, enables uniform spacing between conductive supports, and excellent in adhesion and flexibility.

By the way, there has been considered a method of using a thermosetting epoxy resin as a sealant (Patent Document 1). In the method, upper and lower conductive supports are bonded by the processes of applying the sealant to the conductive supports by a method such as use of a dispenser or screen printing; subsequently leveling the sealant with or without heating; then bonding the upper and lower conductive supports by using alignment reference markings; and pressing the sealant. Examples of a curing agent for the thermosetting epoxy resin used herein include amines, imidazoles, or hydrazides. Such sealants for photoelectric conversion devices have problems of insufficient adhesion and moisture resistance reliability. In order to overcome the problems, Patent Document 2 discloses a technique of using a phenol novolac resin as a curing agent for an epoxy resin. Patent Document 2 also discloses that an epoxy resin liquid composition obtained by adding a solvent to an epoxy resin and a phenolic novolac resin so that the composition can be applied is excellent in moisture resistance as sealants for photoelectric conversion devices.

In the case of producing photoelectric conversion devices in quantity, it is conceivable to use ultraviolet curable sealants containing ultraviolet curable resins as main resin components. Such ultraviolet curable sealants, however, have a drawback of being less prone to cure by ultraviolet rays because an iodine-based redox is used in the charge transfer layers of photoelectric conversion devices. In addition, even if the compounds cure, the compounds have a problem of insufficient adhesion strength because the compounds shrink greatly on photo-curing. Furthermore, another problem occurs that metallic wiring portions on substrates cut off light to generate areas of sealants which are not exposed to light, and the areas do not cure.

Patent Document 1: JP-A-2002-368236
Patent Document 2: Japanese Patent No. 3162179
Patent Document 3: International Publication No. WO2002/011213
Patent Document 4: JP-A-2003-059547
Non-Patent Document 1: C. J. Barbe, F Arendse, P Compt and M. Graetzel J. Am. Ceram. Soc., 80, 12, 3157-71 (1997)

### DISCLOSURE OF THE INVENTION

### PROBLEMS TO BE SOLVED BY THE INVENTION

An object of the present invention is to provide a sealant for photoelectric conversion devices with which upper and lower conductive supports are bonded easily on producing photoelectric conversion devices, and obtained sealed portions are excellent in adhesion strength, moisture resistance reliability, flexibility, and the like.

### MEANS FOR SOLVING THE PROBLEMS

The present inventors have studied thoroughly in order to overcome the problems, and have found that use of a resin composition having a specific composition overcomes the problems. Thus the present invention has been accomplished.
That is, the present invention relates to:
(1) A sealant for a photoelectric conversion device, characterized by comprising (a) an epoxy resin, (b) a heat curing agent, (c) epoxy (meth)acrylate, and (d) a photopolymerization initiator,
(2) The sealant for a photoelectric conversion device according to (1), wherein the heat curing agent (b) is at least one agent selected from the group consisting of hydrazides, amines, acid anhydrides, imidazoles, and polyhydric phenols,
(3) The sealant for a photoelectric conversion device according to (1) or (2), wherein the epoxy (meth)acrylate (c) is bisphenol A type epoxy (meth)acrylate, novolac type epoxy (meth)acrylate, or resorcin (meth)acrylate,
(4) The sealant for a photoelectric conversion device according to any one of (1) to (3), wherein the photopolymerization initiator (d) is at least one initiator selected from the group consisting of acetophenone based, benzoin based, benzophenone based, thioxanthone based, carbazole based, anthraquinone based, acylphosphine based, and acridine based photopolymerization initiators,
(5) The sealant for a photoelectric conversion device according to any one of (1) to (4), further comprising (e) filler,
(6) The sealant for a photoelectric conversion device according to (5), wherein the filler (e) is at least one filler selected from the group consisting of hydrous magnesium silicate, calcium carbonate, aluminum oxide, crystalline silica and molten silica; and the filler (e) has an average particle diameter equal to or less than 3 µm,
(7) The sealant for a photoelectric conversion device according to any one of (1) to (6), further comprising (f) a silane coupling agent,
(8) The sealant for a photoelectric conversion device according to (7), wherein the silane coupling agent (f) is glycidyl ethoxysilanes or glycidyl methoxysilanes,
(9) The sealant for a photoelectric conversion device according to any one of (1) to (8), further comprising (g) an ion catcher,
(10) The sealant for a photoelectric conversion device according to (9), wherein the ion catcher (g) is at least one catcher selected from the group consisting of bismuth oxide based, antimony oxide based, titanium phosphate based, zirconium phosphate based, and hydrotalcite based ion catchers,
(11) A photoelectric conversion device wherein a first conductive support comprising a semiconductor containing layer and a second conductive support comprising a counter electrode are placed so that the supports face each other with a predetermined spacing; a charge transfer layer is interposed in a gap between the supports; and seal is provided on the periphery of the conductive supports by using the sealant for a photoelectric conversion device according to any one of (1) to (10),
(12) A solar cell comprising the photoelectric conversion device according to (11), and
(13) The solar cell according to (12), characterized by comprising at least one sensitizing agent selected from the following compounds (3), (4), (5), (6), and (7).

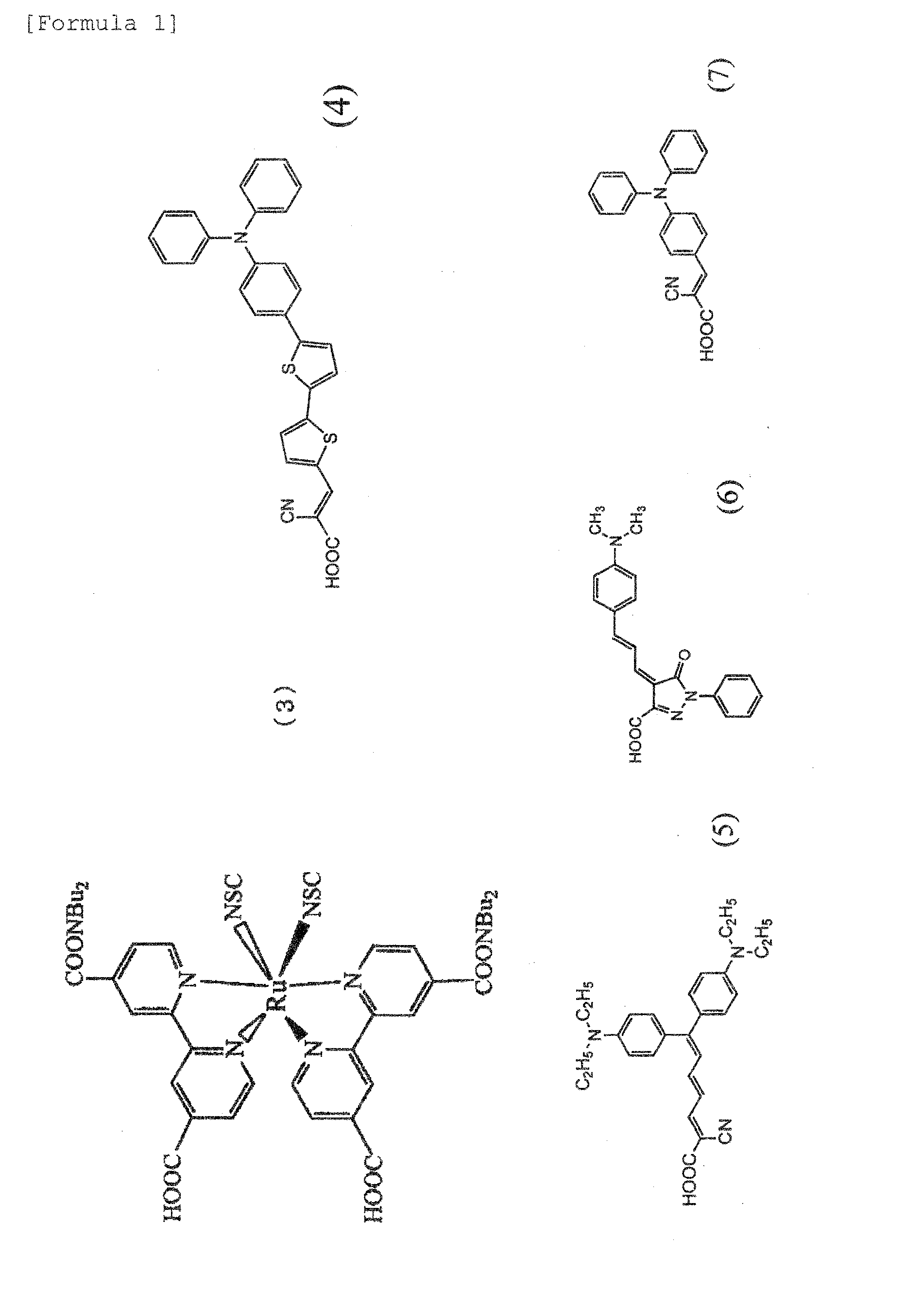

### ADVANTAGES OF THE INVENTION

Sealants for photoelectric conversion devices according to the present invention hardly contaminate charge transfer layers in processes for producing photoelectric conversion devices, and is excellent in application workability to substrates, bonding properties, adhesion strength, available time at room temperature (pot life), and curability in low temperatures. Photoelectric conversion devices according to the present invention obtained by using such sealants do not cause operation failure due to contaminated charge transfer layers, and is excellent in adhesion and moisture resistance reliability. In addition, by using sealants for photoelectric conversion devices according to the present invention, photoelectric conversion devices are produced at a high yield and productivity can be increased.

### BEST MODE FOR CARRYING OUT THE INVENTION

In a photoelectric conversion device wherein a first conductive support comprising a semiconductor containing layer and a second conductive support comprising a counter electrode are placed so that the supports face each other with a predetermined spacing; a charge transfer layer is interposed in the gap between the supports; and seal is provided on the periphery of the conductive supports, sealants for photoelectric conversion devices according to the present invention (hereinafter, sometimes simply referred to as sealants) are used as the seal. The sealants are characterized by comprising (a) an epoxy resin, (b) a heat curing agent, (c) epoxy (meth)acrylate, and (d) a photopolymerization initiator.

As the (a) epoxy resin used in the present invention includes epoxy resins comprising at least two epoxy groups intramolecularly. Examples of such epoxy resins may include: a novolac type epoxy resin, bisphenol A type epoxy resin, bisphenol F type epoxy resin, biphenyl type epoxy resin, and triphenylmethane type epoxy resin. More specifically, non-limiting examples of such epoxy resins may include the following solid or liquid epoxy resins: condensation polymers between bisphenol A, bisphenol F, bisphenol S, fluorene bisphenol., terpene diphenol, 4,4'-biphenol, 2,2'-biphenol, 3,3',5,5'-tetramethyl-[1,1'-biphenyl]-4,4'-diol, hydroquinone, resorcin, naphthalenediol, tris(4-hydroxyphenyl)methane, 1,1,2,2-tetrakis(4-hydroxyphenyl)ethane, or phenols such as phenol, alkyl-substituted phenols, naphthol, alkyl-substituted naphthols, dihydroxybenzene, or dihydroxynaphthalene; and formaldehyde, acetaldehyde, benzaldehyde, p-hydroxybenzaldehyde, o-hydroxybenzaldehyde, p-hydroxyacetophenone, o-hydroxyacetophenone, dicyclopentadiene, furfural, 4,4'-bis(chloromethyl)-1,1'-biphenyl, 4,4'-bis(methoxymethyl)-1,1'-biphenyl, 1,4'-bis(chloromethyl)benzene, 1,4-bis(methoxymethyl)benzene, or the like; modified compounds of the condensation polymers; halogenated bisphenols such as tetrabromobisphenol A; glycidyl ether compounds derived from alcohols; alicyclic epoxy resins, glycidyl amine type epoxy resins, and glycidyl ester type epoxy resins. These resins may be used alone or in combination of two or more. The epoxy resins facilitate decrease of the resin viscosity of sealants for photoelectric conversion devices according to the present invention. Use of the epoxy resins enables bonding process at room temperature, and also facilitates forming of gaps.

In order to reduce contamination by sealants to charge transfer layers as much as possible, sealants according to the present invention preferably contain hydrolyzable chlorine as less as possible. The (a) epoxy resin to be used also preferably contains hydrolyzable chlorine as less as possible, for example, 600 ppm or less. The amount of hydrolyzable chlorine can be determined, for example, by dissolving about 0.5 g of an epoxy resin into 20 ml of dioxane, refluxing this solution with a 5 ml solution of 1 N KOH/ethanol for 30 minutes, and titrating this solution with a 0.01 N solution of silver nitrate.

The content of the (a) epoxy resin used in the present invention is generally 5 to 80% by weight, preferably 10 to 30% by weight based on a sealant for a photoelectric conversion device according to the present invention.

The heat curing agent (b) used in the present invention is not particularly restricted as long as a reaction occurs between the heat curing agent (b) and epoxy resins to form cured resins. But, it is more preferred that the curing agent on being heated triggers a reaction (curing) uniformly and rapidly without contaminating charge transfer layers by sealants; the curing agent hardly changes its viscosity with time on being used at room temperature; or the like. In addition, in order to minimize deterioration of properties of charge transfer layers to be sealed, the sealants are required to be curable at low temperatures such as at 120°C for an hour. In consideration of those mentioned above, preferred heat curing agents in the present invention are hydrazides, amines, acid anhydrides, imidazoles and polyhydric phenols; and more preferably, hydrazides, and polyhydric phenols. These heat curing agents may be used alone or in combination of two or more thereof.

Preferred hydrazides are polyfunctional dihydrazides comprising two or more hydrazide groups intramolecularly. Non-limiting specific examples of polyfunctional dihydrazides comprising two or more hydrazide groups intramolecularly may include: fatty-acid-skeleton-based dibasic acid dihydrazides such as oxalic acid dihydrazide, malonic acid dihydrazide, succinic acid dihydrazide, adipic acid dihydrazide, adipic acid dihydrazide, pimelic acid dihydrazide, suberic acid dihydrazide, azelaic acid dihydrazide, sebacic acid dihydrazide, dodecanedioic acid dihydrazide, hexadecanoic acid dihydrazide, maleic acid dihydrazide, fumaric acid dihydrazide, diglycolic acid dihydrazide, tartaric acid dihydrazide, or malic acid dihydrazide; aromatic dihydrazides such as isophthalic acid dihydrazide, terephthalic acid dihydrazide, 2,6-naphthoic acid dihydrazide, 4,4-bis benzene dihydrazide, 1,4-naphthoic acid dihydrazide, 2,6-pyridine dihydrazide, 1,2,4-benzene trihydrazide, pyromellitic acid tetrahydrazide, or 1,4,5,8-naphthoic acid tetrahydrazide; and dihydrazides comprising a valinehydantoin skeleton such as 1,3-bis(hydrazinocarbonoethyl)-5-isopropylhydantoin. Among these polyfunctional dihydrazides, particularly preferred are isophthalic acid dihydrazide and dihydrazides having a valinehydantoin skeleton.

When these polyfunctional dihydrazides are used as the heat curing agent (b), uniformly dispersed dihydrazides having small particle diameter are preferably used so that the dihydrazides function as latent curing agents. Large average particle diameter of the dihydrazides can cause failures such as being incapable of forming a gap on bonding two substrates (conductive supports) for producing photoelectric conversion devices with narrow gaps. The average particle diameter is preferably equal to or less than 3 µm, and more preferably equal to or less than 2 µm. By the same reason, the maximum particle diameter of the heat curing agent (b) is preferably equal to or less than 8 µm, and more preferably equal to or less than 5 µm. The particle diameter of the heat curing agent (b) can be determined, for example, by using a laser diffraction and scattering method particle diameter distribution measuring instrument (dry type) (LMS-30 manufactured by SEISHIN ENTERPRISE Co., Ltd.).

As for amines used as the heat curing agent (b) in the present invention, any amines known as curing agents for epoxy resins may be used. Preferred specific examples of the amines may include polyamide resins synthesized from diaminodiphenylmethane, diethylenetriamine, triethylenetetramine, diaminodiphenyl sulfone, isophoronediamine, dicyandiamide, linolenic acid dimer, or ethylenediamine.

As for acid anhydrides used as the heat curing agent (b) in the present invention, any acid anhydrides known as curing agents for epoxy resins may be used. Preferred specific examples of the acid anhydrides may include: phthalic anhydride, trimellitic anhydride, pyromellitic anhydride, maleic anhydride, tetrahydrophthalic anhydride, methyltatrahydraphthalic anhydride, methylnadic anhydride, hexahydrophthalic anhydride, and methylhexahydrophthalic anhydride.

As for imidazoles used as the heat curing agent (b) in the present invention, any imidazoles known as curing agents for epoxy resins may be used. Preferred specific examples of the imidazoles may include: 2-ethylimidazole, 2-methylimidazole, 2-phenylimidazole, 2-undecylimidazole, 2-heptadecylimidazole, 2-ethyl-4-methylimidazole, 2-phenyl-4-methylimidazole, 1-benzyl-2-phenylimidazole, 1-benzyl-2-methylimidazole, 1-cyanoethyl-2-methylimidazole, 1-cyanoethyl-2-phenylimidazole, 1-cyanoethyl-2-undecylimidazole, 2,4-dicyano-6(2'-methylimidazole(1'))ethyl-s-triazine, and 2,4-dicyano-6(2'-undecylimidazole(1'))ethyl-s-triazine.

As for polyhydric phenols used as the heat curing agent (b) in the present invention, any polyhydric phenols known as curing agents for epoxy resins may be used. But, it is preferable to use polyhydric phenols that facilitate forming of homogeneous system of sealants for photoelectric conversion devices according to the present invention. Specific examples of such polyhydric phenols may include: polyfunctional novolacs such as phenolformaldehyde condensation polymer, cresol-formaldehyde condensation polymer, hydroxybenzaldehyde-phenol condensation polymer, cresol-naphthol-formaldehyde condensation polymer, resorcin-formalin condensation polymer, furfural-phenol condensation polymer, or α-hydroxyphenyl-ω-hydropoly(biphenyldimethylene-hydroxyphenylene); condensation polymers between bisphenol A, bisphenol F, bisphenol S, thiodiphenol, 4,4'-biphenylphenol, dihydroxynaphthalene, fluorene bisphenol, terpene diphenol, 2,2'-biphenol, 3,3',5,5'-tatramethyl-[1,1'-biphenyl]-4,4'-diol, hydroquinone, resorcin, naphthalenediol, tris(4-hydroxyphanyl) methane, 1,1,2,2-tetrakis(4-hydroxyphenyl)ethane, or phenols such as phenol, alkyl-substituted phenols, naphthol, alkyl-substituted naphthols, or dihydroxybenzene; and formaldehyde, acetaldehyde, benzaldehyde, p-hydroxybenzaldehyde, o-hydroxybenzaldehyde, p-hydroxyacetophenone, o-hydroxyacetophenone, dicyclopentadiene, furfural, 4,4'-bis(chloromethyl)-1,1'-biphenyl, 4,4'-bis(methoxymethyl)-1,1'-biphenyl, 1,4'-bis(chloromethyl)benzene, 1,4'-bis(methoxymethyl)benzene, or the like; modified compounds of the condensation polymers; halogenated bisphenols such as tetrabromobisphenol A; and condensation products between terpene and phenols.

The content of the heat curing agent (b) contained in a sealant for a photoelectric conversion device according to the present invention is generally 2 to 20% by weight, preferably 2 to 10% by weight based on the sealant. Note that a preferred blending ratio of the heat curing agent (b) in a sealant according to the present invention is 0.8 to 3.0 equivalents relative to active hydrogen, more preferably 0.9 to 2.0 equivalents based on the (a) epoxy resin. When the amount of the heat curing agent (b) is less than 0.8 equivalents based on the (a) epoxy resin, a heat curing reaction does not occur sufficiently and obtained sealants may have low adhesive strength and low glass transition temperature. In contrast, when the amount is greater than 3.0 equivalents, the heat curing agent remains and obtained sealants may have low adhesive strength and deteriorated pot life.

The epoxy (meth)acrylate (c) used in the present invention is not particularly restricted, but can be obtained by esterifying (meth)acrylic acid with the abovementioned bifunctional or more (a) epoxy resins in the presence of a catalyst and a polymerization inhibitor. Examples of the bifunctional or more (a) epoxy resins may include: bisphenol A type epoxy resins, bisphenol F type epoxy resins, bisphenol S type epoxy resins, thiodiphenol type epoxy resins, phenolic novolac type epoxy resins, cresol novolac type epoxy resins, bisphenol A novolac type epoxy resins, bisphenol F novolac type epoxy resins, alicyclic epoxy resins, aliphatic chain epoxy resins, glycidyl ester type epoxy resins, glycidyl amine type epoxy resins, hydantoin type epoxy resins, isocyanurate type epoxy resins, phenolic novolac type epoxy resins comprising a triphenol methane skeleton, diglycidyl ethers of bifunctional phenols, diglycidyl ethers of bifunctional alcohols, halogenated compounds thereof, and hydrogenated compounds thereof. Among these resins, those having low solubility in charge transfer layers are preferable. Specifically, preferred are (meth)acrylates of bifunctional or more aromatic epoxy resins, more preferably (meth)acrylates of bifunctional aromatic epoxy resins. Specifically, preferred are (meth)acrylates of bisphenol type epoxy resins, (meth)acrylates of novolac type epoxy resins, and (meth)acrylate of resorcin. Also preferred are (meth)acrylates of epoxy resins comprising alkylene oxide units.

The epoxy (meth)acrylate (c) used in the present invention preferably has low solubility in charge transfer layers. For example, preferred are (meth)acrylates of bifunctional or more aromatic epoxy resins and (meth)acrylates of epoxy resins comprising alkylene oxide units, and more preferably (meth)acrylates of bifunctional aromatic epoxy resins. Preferred examples of the (meth)acrylates of bifunctional aromatic epoxy resins may include (meth)acrylates of bisphenol A type epoxy resins, (meth)acrylates of novolac type epoxy resins, and (meth)acrylate of resorcin.
Note that the term (meth)acrylate means both acrylate and methacrylate. Likewise, in synonyms comprising (meth), for example, the term (meth)acrylic group means both an acrylic group and a methacrylic group.

One or more of the following diluting solvents may be added on the esterification reaction: aromatic hydrocarbons such as toluene or xylene; esters such as ethyl acetate or butyl acetate; ethers such as 1,4-dioxane or tetrahydrofuran; ketones such as methyl ethyl ketone or methyl isobutyl ketone; glycol derivatives such as butylcellosolve acetate, carbitol acetate, diethyleneglycoldimethylether, or propylene glycol monomethyl ether acetate; alicyclic hydrocarbons such as cyclohexanone or cyclohexanol; and petroleum solvents such as petroleum ethers or petroleum naphtha. When these diluting solvents are used, the solvents are required to be evaporated under reduced pressure after the reaction, and thus preferred are solvents having low boiling points and high volatility. Specifically, it is preferred to use toluene, methyl ethyl ketone, methyl isobutyl ketone, or carbitol acetate. It is preferred to use a catalyst for promoting the reaction. Examples of the usable catalyst may include: benzyldimethylamine, triethylamine, benzyltrimethylammonium chloride, triphenyl phosphine, and triphenyl stibine. The amount of the catalyst to be used is preferably 0.1 to 10% by weight, more preferably 0.3 to 5% by weight based on a mixture of reaction materials. It is preferred to use a polymerization inhibitor for inhibiting polymerization of (meth)acrylic groups during the reaction. Examples of the polymerization inhibitor may include: methoquinone, hydroquinone, methylhydroquinone, phenothiazine, and dibutylhydroxytoluene. The amount of the polymerization inhibitor to be used is preferably 0.01 to 1% by weight, particularly preferably 0.05 to 0.5% by weight based on a mixture of reaction materials. Reaction temperature is generally 60 to 150°C, particularly preferably 80 to 120°C. Reaction time is preferably 5 to 60 hours.

The content of the epoxy (meth)acrylate (c) used in the present invention is generally 5 to 80% by weight, preferably 50 to 70% by weight based on a sealant for a photoelectric conversion device according to the present invention.

The photopolymerization initiator (d) used for sealants for photoelectric conversion devices according to the present invention preferably has sensitivity to around i-line (365 nm), which has relatively little effect on the properties of charge transfer layers; and hardly contaminates charge transfer layers. Examples of such photopolymerization initiators may include: acetophenone based photopolymerization initiators such as benzyl dimethyl ketal, 1-hydraxycyclohexyl phenyl ketone, 2-hydroxy-2-methyl-1-phenyl-propane-1-one, or 2-methyl-[4-(methylthio)phenyl]-2-morphorino-1-propane; benzoin based photopolymerization initiators such as benzyl methyl ketal ; thioxanthone based photopolymerization initiators such as diethylthioxanthone; benzophenone based such as benzophenone; anthraquinone based photopolymerization initiators such as 2-ethylanthraquinone; acylphosphine based photopolymerization initiators such as 2,4,6-trimethyl benzoyldiphenylphosphine oxide; carbazole based photopolymerization initiators such as 3,6-bis(2-methyl-2-morphorino-propionyl)-9-n-octylcarbazole; and acridine based photopolymerization initiators such as 1,7-bis(9-acridyl)heptane. Among these initiators, particularly preferable initiators are, for example, carbazole based photopolymerization initiators such as 3,6-bis(2-methyl-2-morphorino-propionyl)-9-n-octylcarbazole; and acridine based photopolymerization initiators such as 1,7-bis(9-acridyl)heptane.

The content of the photopolymerization initiator (d) used in the present invention is generally 0.1 to 3% by weight, preferably 1 to 2% by weight based on a sealant for a photoelectric conversion device according to the present invention. Note that a blending ratio of the photopolymerization initiator (d) to the epoxy (meth)acrylate (c) component in a sealant for a photoelectric conversion device according to the present invention is generally 0.1 to 10 parts by weight, more preferably 0.5 to 3 parts by weight based on 100 parts by weight of the (c) component. When the amount of the photopolymerization initiator is less than 0.1 parts by weight, sufficient photocuring reactions possibly do not occur. When the amount of the photopolymerization initiator is greater than 10 parts by weight, the initiator can contaminate charge transfer layers or cured resins having deteriorated properties can be obtained.

In the present invention, if necessary, sealants for photoelectric conversion devices according to the present invention can further comprise (e) filler. Specific examples of the filler (e) may include: molten silica, crystalline silica, silicon carbide, silicon nitride, boron nitride, calcium carbonate, magnesium carbonate, barium sulfate, calcium sulfate, mica, talc, clay, alumina (aluminum oxide), magnesium oxide, zirconium oxide, aluminum hydroxide, magnesium hydroxide, hydrous magnesium silicate, calcium silicate, aluminum silicate, lithium aluminum silicate, zirconium silicate, barium titanate, glass fibers, carbon fibers, molybdenum disulfide, and asbestos. Among these fillers, preferred are hydrous magnesium silicate, calcium carbonate, aluminum oxide, crystalline silica, molten silica, and the like. The fillers may be used alone or in combination of two or more. The filler (e) used in the present invention preferably has an average particle diameter equal to or less than 3 µm. When the average particle diameter is greater than 3 µm, gaps possibly cannot be formed properly on bonding upper and lower substrates in producing photoelectric conversion devices.

The content of the filler (e) used in the present invention is generally 5 to 50% by weight, preferably 15 to 25% by weight based on a sealant for a photoelectric conversion device according to the present invention. When the content of the filler is less than 5% by weight, sealants can have deteriorated adhesive strength to substrates of glass, plastic, or the like, and problems can occur such as deterioration of moisture resistance reliability or deterioration of adhesive strength after sealants absorb moisture. When the content of the filler is greater than 40% by weight, appropriate gaps possibly cannot be formed for charge transfer layers on producing photoelectric conversion devices.

Sealants for photoelectric conversion devices according to the present invention can further comprise (f) a silane coupling agent for enhancing adhesion strength of the compounds. As the silane coupling agent (f), any silane coupling agent can be used as long as the agent enhances the adhesion strength of sealants to substrates. Specific examples of usable silane coupling agents may include: glycidylmethoxysilanes such as 3-glycidoxypropyltrimethoxysilane, 3-glycidoxypropylmethyldimethoxysilane, 3-glycidoxypropylmethyldimethoxysilane, 2- (3,4-epoxycyclohexyl)ethyltrimethoxysilane, N-phenyl-γ-aminopropyltrimethoxysilane, N-(2-aminoethyl)3-aminopropylmethyldimethoxysilane, or N-(2-aminoethyl) 3-aminopropylmethyldimethoxysilane; and glycidylethoxysilanes such as 3-aminopropyltriethoxysil,ane, 3-mercaptopropyltriethoxysilane, vinyltrimethoxysilane, N-(2-(vinylbenzylamino)ethyl)3-aminopropyltriethoxysilane hydrochloride, 3-methacryloxypropyltriethoxysilane, 3-chloropropylmethyldiethoxysilane, or 3-chloropropyltriethoxysilane. These silane coupling agents may be used alone or in combination of two or more. Among the agents, silane coupling agents comprising amino groups are preferable for obtaining better adhesion strength. Preferred silane coupling agents among above agents include N-(2-aminoethyl)3-aminopropylmethyldimethoxysilane, N-(2-aminoethyl)3-aminopropylmethyldimethoxysilane, 3-aminopropyltriethoxysilane, and N-(2-(vinylbenzylamino)ethyl)3-aminopropyltriethoxysilane hydrochloride.
When a silane coupling agent is used in the present invention, the content of the silane coupling agent is generally 0.2 to 2% by weight, preferably 0.5 to 1.5% by weight in a sealant for a photoelectric conversion device according to the present invention.

If necessary, sealants for photoelectric conversion devices according to the present invention can further comprise (g) an ion catcher. Ion catchers prevent the resistivity value of charge transfer layers from decreasing by adsorbing and immobilizing impurities, particularly inorganic ions in sealants to reduce inorganic ions leaching into charge transfer layers. The ion catchers are preferably inorganic compounds capable of scavenging ions, in particular, inorganic compounds capable of scavenging phosphoric acid, phosphorous acid, organic acid anions, halogen anions, alkali metal cations, alkaline earth metal cations, or the like. Examples of usable ion catchers may include: bismuth oxide based ion catchers represented by a general formula BiO_{X}(OH)_{Y}(NO₃)_{Z} wherein X is a positive number of 0.9 to 1.1, Y is a positive number of 0.6 to 0.8, and Z is a positive number of 0.2 to 0.4; antimony oxide based ion catchers; titanium phosphate based ion catchers; zirconium phosphate based ion catchers; and hydrotalcite based ion catchers represented by a general formula MgₓAl_{Y}(OH) _{2x+3Y-2Z} (CO₃) _{z}·mH₂O wherein X, Y, and Z are positive numbers that satisfy 2X+3Y-2Z≥0, and m represents a positive number. These ion catchers may be used alone or in combination of two or more. The ion catchers are commercially and easily available as IXE-100 (a tradename for a zirconium phosphate based ion catcher manufactured by TOAGOSEI CO., LTD.); IXE-300 (a tradename for an antimony oxide based ion catcher manufactured by TOAGOSEI CO., LTD.); IXE-400 (a tradename for a titanium phosphate based ion catcher manufactured by TOAGOSEI CO., LTD.); IXE-500 (a tradename for a bismuth oxide based ion catcher manufactured by TOAGOSEI CO., LTD.); IXE-600 (a tradename for an antimony oxide and bismuth oxide based ion catcher manufactured by TOAGOSEI CO., LTD.); DHT-4A (a tradename for a hydrotalcite based ion catcher manufactured by Kyowa Chemical Industry Co., Ltd.); or Kyoward KW-2000 (a tradename for a hydrotalcite based ion catcher manufactured by Kyowa Chemical Industry Co., Ltd.). When a (g) ion catcher is used in the present invention, the content of the ion catcher (g) is generally 0.01 to 5% by weight, preferably 0.5 to 2% by weight based on a sealant for a photoelectric conversion device according to the present invention.

Sealants for photoelectric conversion devices according to the present invention can further comprise a curable resin comprising a (meth)acrylic group such as a (meth)acrylate monomer and/or a (meth)acrylate oligomer for enhancing the curing reactivity and controlling the viscosity of the sealants. Examples of the monomer and oligomer may include a reaction product of dipentaerythritol and (meth)acrylic acid; and a reaction product of dipentaerythritol caprolactone and (meth) ic acid. But, the monomer and oligomer are not particularly restricted as long as they hardly contaminate charge transfer layers.
If necessary, sealants according to the present invention can further comprise organic solvents, organic fillers, stress relaxation agents, and additives such as pigments, leveling agents, and antifoaming agents.

Sealants for photoelectric conversion devices according to the present invention can be produced by mixing, if necessary with stirring, the (a) epoxy resin, the heat curing agent (b), the epoxy (meth)acrylate (c), and the photopolymerization initiator (d), if necessary, the filler (e), the silane coupling agent (f), and the ion catcher (g) in any order so that the sealants comprise each component in the abovementioned content; and subsequently mixing the components uniformly by using mixing equipment such as a triple roll mill, a sand mill, or a ball mill. If necessary, after the components are mixed, the mixture may be filtered to remove impurities.

Sealants for photoelectric conversion devices according to the present invention preferably contain hydrolyzable chlorine as less as possible derived from epoxy resins for reducing contamination by the sealants to charge transfer layers. Thus as to the (a) epoxy resin, epoxy resins used to prepare the epoxy (meth)acrylate (c), and other epoxy resins used, it is preferred to use epoxy resins containing hydrolyzable chlorine equal to or less than 600 ppm in total, more preferably equal to or less than 300 ppm in total. The content of hydrolyzable chlorine in epoxy resins is mentioned above.

Sealants for photoelectric conversion devices according to the present invention are suitable for a method of producing photoelectric conversion devices in which charge transfer layers are formed by injection before or after two substrates (conductive supports) are bonded. Sealing can be conducted by exposing the weir of a sealant according to the present invention interposed between two substrates to light to conduct primary curing; and by applying heat to conduct secondary curing. Examples of the method of applying sealants according to the present invention to the substrate may include a bar coater method, dip coating method, spin coating method, spray method, screen printing method, doctor blade method, and dispensing method. The application methods can be properly selected or combined depending on the types or shapes of substrates, but it is preferred to use spray method, screen printing method, or dispensing method in view of productivity. Photoelectric conversion devices to which sealants for photoelectric conversion devices according to the present invention are applicable include any element generally converting light energy into electric energy. Closed circuit photoelectric conversion devices equipped with leads for extracting generated current from the elements are defined as solar cells. Sealants for photoelectric conversion devices according to the present invention are particularly optimal for producing dye sensitized photoelectric conversion devices and dye sensitized solar cells.

Hereinafter, there are described further in detail photoelectric conversion devices and solar cells produced by using sealants for photoelectric conversion devices according to the present invention.
A dye sensitized photoelectric conversion device is mainly composed of a semiconductor electrode sensitized by using a dye provided to a conductive support, a counter electrode, and a charge transfer layer.
The conductive support is, for example, obtained by forming a thin film (hereinafter, referred to as a semiconductor containing layer) made of a conductive material (oxide semiconductor) represented by FTO (tin oxide doped with fluorine), ATO (tin oxide doped with antimony), or ITO (tin oxide doped with indium) on the surface of a substrate such as glass, plastic, a polymer film, quartz, or silicon. The electrical conductivity of the conductive support is generally 1000 Ω/cm² or less, preferably 100 Ω/cm² or less. Herein, the conductive support (substrate) may be made of glass, quartz, plastic, silicon, or the like, and as to the thickness of the substrate, a film form substrate to a plate form substrate may be used. The thickness of the substrate is generally 0.01 to 10 mm, and at least one of the two substrates is optically transparent.

Preferred oxide semiconductors for preparing the semiconductor containing layer are particles of metallic chalcogenide. Specific examples thereof may include: oxides of transition metals such as Ti, Zn, Sn, Nb, W, In, Zr, Y, La, or Ta; oxides of Al; oxides of Si; perovskite type oxides such as StTiO₃, CaTiO₃, or BaTiO₃. Among these, particularly preferred are TiO₂, ZnO, and SnO₂. Combination of the metallic chalcogenides may be used, and a preferred example thereof is SnO₂-ZnO mixed system. The primary particle diameter of oxide semiconductors to be used herein is generally 1 to 200 nm, preferably 1 to 50 nm. In the case of a mixed system, the oxide semiconductors may be mixed in the forms of particles, slurries, or pastes as described later, or combinations thereof.

The semiconductor containing layer can be prepared by methods such as forming a thin film made of oxide semiconductor directly on a substrate by deposition; forming the thin film by applying or coating slurry or paste to a substrate and subsequently applying pressure to the slurry or the paste; electrically depositing the thin film by using a substrate as an electrode; or forming the thin film by applying or coating slurry or paste to a substrate and subsequently drying, curing or firing the slurry or the paste. Examples of the applying or coating method may include a bar coater method, dip coating method, spin coating method, spray method, screen printing method, doctor blade method, and dispensing method. These methods can be properly selected or combined depending on the types or shapes of substrates. The methods of using slurry or paste are preferable in view of the properties of oxide semiconductor electrodes. The slurry can be obtained by dispersing secondary agglomerated particles of oxide semiconductor in a dispersion medium by using a dispersing agent so that the particles generally have a mean primary particle diameter of 1 to 200 nm, or by hydrolysing an alkoxide or the like which is a precursor of oxide semiconductor by a sol-gel method (see Non-Patent Document 1). Combination of oxide semiconductor particles having different particle diameters may also be used.

As for the dispersion medium in which slurry is dispersed, any medium that can disperse oxide semiconductor particles can be used. Examples of the medium may include water, and organic solvents like alcohols such as ethanol, ketones such as acetone or acetylacetone, and hydrocarbons such as hexane. These mediums may be used in combination. Water is preferably used for reducing viscosity change of slurry.

A dispersion stabilizer or the like can be added to slurry for the purpose of obtaining stable primary particles. Non-limiting specific examples of such a dispersion stabilizer may include: self-condensation products of polyhydric alcohols such as polyethylene glycol, or monohydric alcohols such as phenol or octyl alcohol, or co-condensation products among polyhydric alcohols such as polyethylene glycol, and monohydric alcohols such as phenol or octyl alcohol; cellulose derivatives such as hydroxypropyl methylcellulose, hydroxymethylcellulose, hydroxyethylcellulose, or carboxymethylcellulose; polyacrylamide; self-condensation products of acrylamide, (meth)acrylic acid or salts thereof, or (meth)acrylates such as methyl (meth)acrylate or ethyl (meth)acrylate, or co-condensation products among acrylamide, (meth)acrylic acid and salts thereof, and (meth)acrylates such as methyl (meth)acrylate or ethyl (meth)acrylate; polyacrylic acid based derivatives that are water-soluble copolymers of acrylamide, (meth)acrylic acid, salts thereof, (meth) acrylates, or the like, and a hydrophobic monomer such as styrene, ethylene, or propylene; salts of melamine sulfonate formaldehyde condensate; salts of naphthalin sulfonate formaldehyde condensate; lignin sulfonates having high molecular weight; and acids such as hydrochloric acid, nitric acid, or acetic acid. These dispersion stabilizers may be used alone or in combination of two or more.

Among the above stabilizers, preferred are self-condensation products of polyhydric alcohols such as polyethylene glycol, phenol, octyl alcohol, or the like; or co-condensation products among polyhydric alcohols such as polyethylene glycol, phenol octyl alcohol, and the like; poly(meth)acrylic acid, sodium poly(meth)acrylate, potassium poly (meth) acrylate, lithium poly(meth)acrylate, carboxymethylcellulose, hydrochloric acid, nitric acid, acetic acid, and the like.
The concentration of oxide semiconductor in slurry is 1 to 90% by weight, preferably 5 to 80% by weight.

Substrates to which slurry is applied are dried, and subsequently subjected to a firing treatment at temperatures equal to or less than the melting points (melting points or softening points) of used materials. Firing temperature is generally 100 to 900°C, preferably 100 to 600°C, and firing is conducted at temperatures equal to or less than the melting points or the softening points of substrates. Firing time is not particularly restricted, but generally 4 hours or less.

A secondary treatment may be further conducted for the purpose of enhancing the surface smoothness of the semiconductor containing layer (see Non-Patent Document 1). For example, the smoothness can be enhanced by directly immersing the whole substrate provided with a thin film made of semiconductor particles prepared as mentioned above into a solution of alkoxide, chloride, nitrate, sulfide, or the like of the same metal as the semiconductor; and by drying or firing (refiring) the substrate as with above. Examples of the metal alkoxide may include titanium ethoxide, titanium isopropoxide, titanium t-butoxide and n-dibutyldiacetyl tin; and alcoholic solutions thereof are used. Examples of the chloride may include titanium tetrachloride, tin tetrachloride, and zinc chloride; and aqueous solutions thereof are used. Thus obtained oxide semiconductor particles generally have a specific surface of 1 to 1000 m²/g, preferably 10 to 500 m²/g.

Next, there is described a process of making a semiconductor containing layer adsorb a sensitizing dye. The sensitizing dye is not particularly restricted as long as the dye is a metal complex dye containing a metallic element such as ruthenium, an organic dye without containing metals, or a mixture of the metal complex dye and the organic dye; and the dye functions to enhance light absorption in combination with semiconductor particles.

As for a method of making a semiconductor containing layer support a sensitizing dye, for example, the substrate comprising a semiconductor containing layer is immersed in a solution obtained by dissolving a sensitizing dye in a solvent that can dissolve the dye, or in a fluid dispersion obtained by dispersing a dye which has low solubility. The concentration of the dye in the solution or in the fluid dispersion is properly determined depending on the dye. In the solution, a substrate comprising a semiconductor containing layer is immersed. Immersion temperature is generally from ordinary temperature to the boiling point of a solvent, and immersion time is about 1 to 48 hours. Specific examples of the solvent usable for dissolving a sensitizing dye may include: methanol, ethanol, acetonitrile, dimethyl sulfoxide, dimethylformamide, t-butanol, and tetrahydrofuran. These solvents may be used alone or in combination in any proportions. The concentration of the sensitizing dye in a solution is generally 1 × 10⁻⁶ M to 1 M, preferably 1 × 10⁻⁵ M to 1 × 10⁻¹ M. In this way, a substrate is obtained that comprises a dye-sensitized semiconductor containing layer. This substrate is used as a semiconductor electrode.

The dye to be supported may be alone or in combination of two or more types in any proportions. In the case of combination, organic dyes may be combined, or an organic dye and a metal complex dye may be combined. In particular, combination of dyes having different absorption wavelength ranges enables use of wide absorption wavelengths, thereby providing solar cells exhibiting high conversion efficiency. The metal complex dye that can be supported are not particularly restricted, and preferred examples thereof may include phthalocyanines and porphyrins. Examples of the organic dye that can be supported may include: nonmetallic phthalocyanines, nonmetallic porphyrins, cyanine, merocyanine, oxonol, triphenylmethane dyes, methine based dyes of acrylic acid based dyes disclosed in Patent Document 3 or pyrazolone based methine dyes disclosed in Patent Document 4, xanthene based dyes, azo based dyes, anthraquinone based dyes, and perylene based dyes. Preferred dyes are those disclosed in International Patent Publication Nos. WO2002-001667, WO2002-011213, WO2002-071530, JP-A-2002-334729, JP-A-2003-007358, JP-A-2003-017146, JP-A-2003-059547, JP-A-2003-086257, JP-A-2003-115333, JP-A-2003-132965, JP-A-2003-142172, JP-A-2003-151649, JP-A-2003-157915, JP-A-2003-282165, JP-A-2004-014175, JP-A-2004-022222, JP-A-2004-022387, JP-A-2004-0227825, JP-A-2005-005026, JP-A-2005-019130, JP-A-2005-135656, JP-A-2006-079898, JP-A-2006-134649, and International Patent Publication No. WO2006-082061. More preferred dyes are ruthenium complexes, merocyanine, or the methine based dyes of acrylic acid based dyes. In the case of combining dyes, proportions of the dyes are not particularly restricted and selected optimally depending on the dyes. But, it is generally preferred to combine the same moles of dyes, or to use about 10% mole or more of each dye for combination. In the case of making a semiconductor containing layer adsorb a dye by using a solution in which two or more dyes are dissolved or dispersed, the total concentration of the dyes in the solution may be the same as the case of supporting one dye. Solvents usable for combining dyes are the same as those mentioned above, and solvents to be used for each dye may be the same or different. In particular, the dyes are preferably selected from the following compounds (3), (4), (5), (6), and (7).

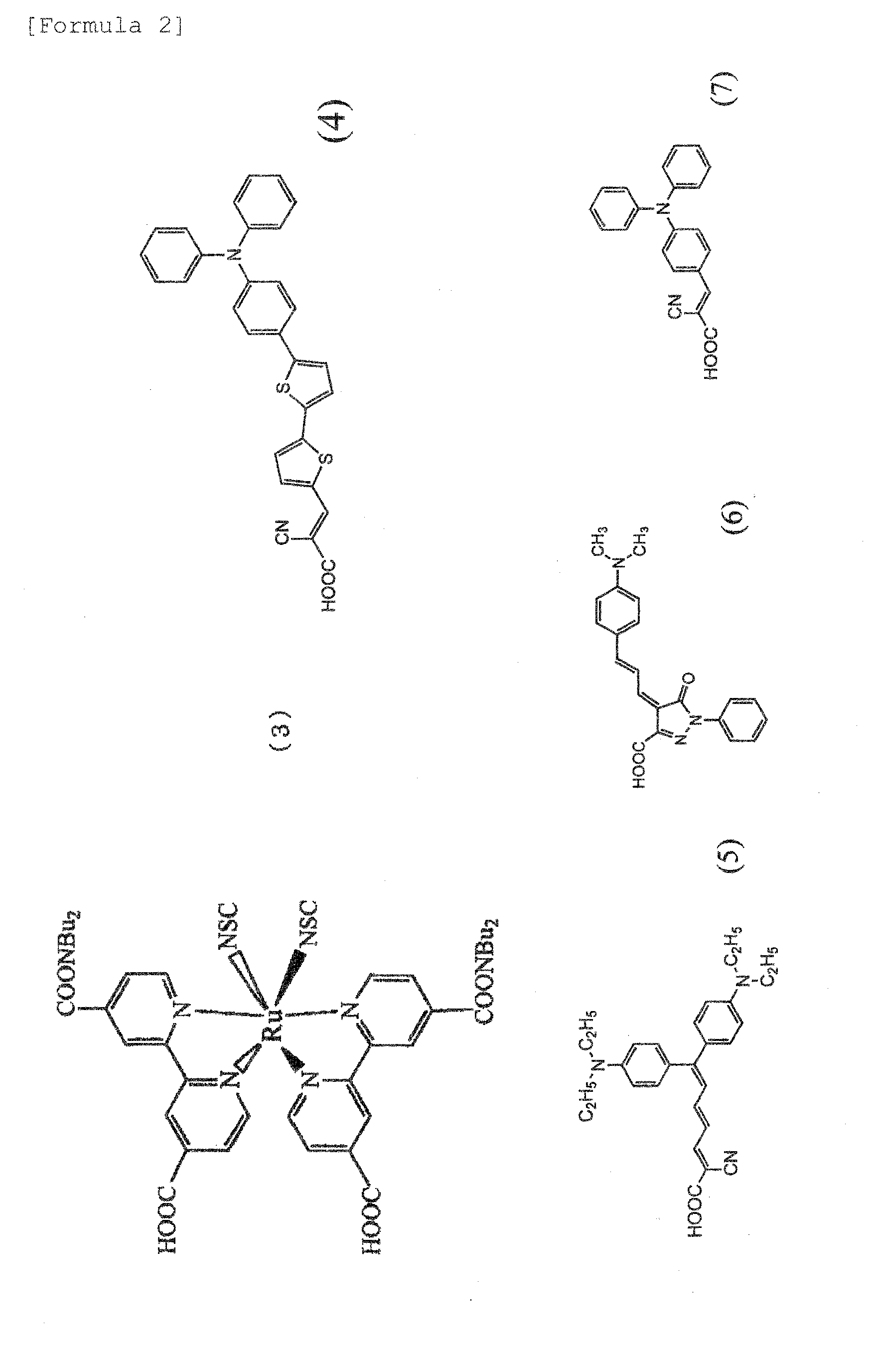

A semiconductor containing layer effectively supports a dye in the copresence of the dye and a inclusion compound for preventing association of the dyes. Examples of the inclusion, compound may include: steroid type compounds such as cholic acid, crown ethers, cyclodextrins, calixarenes, and polyethylene oxides. Preferred inclusion compounds are cholic acid compounds such as cholic acid, deoxycholic acid, chenodeoxycholic acid, methyl cholate, or sodium cholate; and polyethylene oxides. After a semiconductor containing layer supports a dye, the surface of a semiconductor electrode may be treated with an amine compound such as 4-t-butylpyridine. This treatment is conducted, for example, by immersing a substrate provided with a semiconductor containing layer supporting a dye into an ethanol solution of an amine.

As for a counter electrode, it is obtained by depositing platinum, carbon, rhodium, ruthenium, or the like that catalyses the reduction reactions of oxidation-reduction electrolytes onto the surface of a conductive support made of FTO conductive glass or the like; or by applying a precursor of conductive particles to the surface of the conductive support and firing the precursor.

Next, there is described a method of sealing thus obtained substrate comprising a dye-sensitized semiconductor containing layer and the counter electrode by using a sealant for a photoelectric conversion device according to the present invention. First, a spacer (gap control agent) such as glass fiber is added to a sealant according to the present invention. Then the sealant is applied, in a weir form having a hole for injecting a charge transfer layer on the periphery of one of two substrates by using a dispenser or the like, and the solvent of the compound is evaporated by heating, for example, at 100°C for 10 minutes. Then this conductive support and the other conductive support on which platinum or the like is placed, that is, the upper and lower conductive supports, are stacked so that the conductive surfaces of the supports face to each other. The supports are pressed to form the gap.
Examples of the spacer may include: glass fiber, silica beads, or polymer beads. The diameter of the spacer varies depending on a purpose, but the diameter is generally 1 to 100 µm, preferably 4 to 50 µm. The amount of the spacer is generally 0.1 to 4 parts by weight, preferably 0.5 to 2 parts by weight, and more preferably 0.9 to 1.5 parts by weight based on 100 parts by weight of a sealant according to the present invention. After the gap is formed, ultraviolet rays are irradiated to sealing portions by using an ultraviolet irradiation apparatus to photocure the sealant. The dose of ultraviolet rays is generally 500 to 6000 mJ/cm², preferably 1000 to 4000 mJ/cm². After that, the sealant is thermally cured at 90 to 130°C for 1 to 2 hours to complete the curing of the compound. Note that this heating treatment can be conducted, for example, by heating in an oven. The gap of the two electrodes is generally 1 to 100 µm, preferably 4 to 50 µm.

Solar cells according to the present invention are completed by bonding a semiconductor electrode with an oxide semiconductor containing layer supporting a dye and a counter electrode with a predetermined gap as described above; and then by injecting a charge transfer layer into the gap. As for the charge transfer layer, used is a solution obtained by dissolving an oxidation-reduction electrolyte, a hole transport material, or the like into a solvent or a room temperature molten salt (an ionic liquid). Examples of the oxidation-reduction electrolyte may include: a halogen oxidation-reduction electrolyte composed of a halogen compound having halogen ions as counterions and halogen molecules; a metal oxidation-reduction electrolyte of metal complex or the like such as ferrocyanide-ferricyanide, ferrocene-ferricinium ions, or a cobalt complex; and an organic oxidation-reduction electrolyte such as alkylthiol-alkyldisulfide, a viologen dye, or hydroquinone-quinone. But, preferred electrolytes are halogen oxidation-reduction electrolytes. Examples of the halogen molecules in the halogen oxidation-reduction electrolyte composed of a halogen compound and halogen molecules may include iodine molecules and bromine molecules, and iodine molecules are preferable. Examples of the halogen compound may include: halogenated metal salts such as LiI, NaI, KI, CsI, CaI₂, or CuI; or organic quatornary ammonium salts of halogens such as tetraalkylammonium iodide, imidazolium iodide, 1-methyl-3-alkylimidazolium iodide, or pyridinium iodide . But, a preferred halogen compound is salts comprising iodide ions as counterions. Preferred examples of the salt compounds comprising iodide ions as counterions may include: lithium iodide, sodium iodide, and trimethylammonium iodide salt.

When a charge transfer layer is in the form of a solution comprising an oxidation-reduction electrolyte, a solvent used for the electrolyte is electrochemically inert. Examples of a usable solvent may include: acetonitrile, valeronitrile, propylene carbonate, ethylene carbonate, 3-methoxypropionitrile, methoxyacetonitrile, ethylene glycol, propylene glycol, diethylene glycol, triethylene glycol, dimethoxyethane, diethyl carbonate, diethyl ether, diethyl carbonate, dimethyl carbonate, 1,2-dimethoxyethane, dimethylformamide, dimethyl sulfoxide, 1,3-dioxolane, methyl formate, 2-methyltetrahydrofuran, 3-methoxyoxazilidine-2-one, γ-butyrolactone, sulfolane, tetrahydrofuran, and water. Among these solvents, preferred examples may include: acetonitrile, propylene carbonate, ethylene carbonate, 3-methoxypropionitrile, methoxyacetonitrile, ethylene glycol, 3-methyloxazilidine-2-one, and γ-butyrolactone. The solvents may be used alone or in combination of two or more. The concentration of an oxidation-reduction electrolyte is generally 0.01 to 99% by weight, and preferably 0.1 to 90% by weight.

When a charge transfer layer is in the form of a composition comprising an oxidation-reduction electrolyte, what is used like a solvent for the electrolyte is a room temperature melt (an ionic liquid). Examples of the room temperature melt may include: 1-methyl-3-alkylimidazolium iodide, vinylimidazolium tetrafluoride, 1-ethylimidazole sulfonate, alkylimidazolium trifluoromethylsulfonylimide, and 1-methylpyrrolidinium iodide. A charge transfer layer can be a gel electrolyte for the purpose of increasing the durability of a photoelectric conversion device by methods such as dissolving a low molecular gelling agent into a charge transfer layer to increase its viscosity; combining a reactive component and a charge transfer layer, and gelatinizing the layer after the layer is injected; or impregnating a gel polymerized beforehand with a charge transfer layer.

By the way, as an entirely solid charge transfer layer, a hole transport material or a p-type semiconductor can be used instead of oxidation-reduction electrolytes. Examples of usable hole transport materials may include: amine derivatives; conductive polymers such as polyacethylene, polyaniline or polythiophene; and discotic liquid crystal.
Examples of the p-type semiconductor may include CuI and CuSCN.

After a charge transfer layer is injected into the gap between two conductive supports, the injection hole of the charge transfer layer is sealed to obtain a photoelectric conversion device. Examples of a sealant (hole sealant) for sealing the injection hole of the charge transfer layer may include: isobutylene resins and epoxy resins.

An alternative method of preparing a photoelectric conversion device can also be adopted: a weir is formed on the periphery of the semiconductor electrode without forming an injection hole of a charge transfer layer by using a sealant for a photoelectric conversion device according to the present invention; then a charge transfer layer the same as mentioned above is placed in the weir made of the sealant; a counter electrode is placed on the semiconductor electrode under a reduced pressure to bond the both electrodes and simultaneously to form a gap; then the sealant is cured, thereby providing a photoelectric conversion device.

Lead wires are connected to the anode and the cathode of thus obtained photoelectric conversion device, and resistance is interposed therebetween, thereby providing a solar cell according to the present invention.

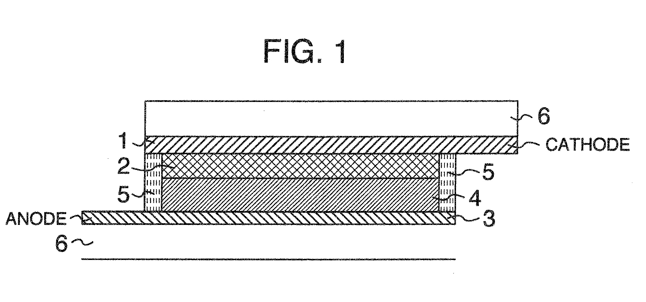

Fig. 1 is a schematic section view of the main structure of a dye sensitized solar cell comprising a photoelectric conversion device prepared by using a sealant according to the present invention. Reference numeral 1 denotes a conductive support the inner side of which has conductivity. Reference numeral 2 denotes a dye-sensitized semiconductor containing layer. Reference numerals 1 and 2 constitute a semiconductor electrode. Reference numeral 3 denotes a counter electrode where platinum or the like is placed on the conductive surface, which is the inner side, of a conductive support. Reference numeral 4 denotes a charge transfer layer placed to be interposed between the conductive supports facing to each other. Reference numeral 5 denotes a sealant. Reference numeral 6 denotes a glass substrate.

Sealants for photoelectric conversion devices according to the present invention hardly contaminate charge transfer layers in processes for producing photoelectric conversion devices, and excellent in application workability to substrates, bonding properties, adhesion strength, available time at room temperature (pot life), and curability in low temperatures. Thus obtained photoelectric conversion devices according to the present invention do not cause operation failure due to contaminated charge transfer layers, and also excellent in adhesion and moisture resistance reliability. Solar cells prepared by using such photoelectric conversion devices can be produced efficiently, and the solar cells are excellent in durability.

### EXAMPLES

The present invention is described further in detail with referring to examples, however, the invention is not restricted to the examples.

### Synthesis Example 1: Synthesis of ethylene oxide addition bisphenol S type epoxy resin (epoxy resin A)

To a flask equipped with a thermometer, a dropping funnel, a condenser, and a stirrer, 169 parts of SEO-2 (a tradename for ethylene oxide addition bisphenol S manufactured by NICCA CHEMICAL CO., LTD., melting point: 183°C, and purity: 99.5%), 370 parts of epichlorohydrin, 185 parts of dimethyl sulfoxide, and 5 parts of tetramethylammonium chloride were added and dissolved with stirring; this solution was heated to 50°C. Then 60 parts of flake form sodium hydroxide were separately added thereto over 100 minutes; subsequently a reaction was further effected at 50°C for 3 hours.
After the reaction was complete, 400 parts of water was added thereto and this solution was washed. Excessive epichlorohydrin and the like were evaporated from an oil layer at 130°C under a reduced pressure by using a rotary evaporator. To thus obtained residue, 450 parts of methyl isobutyl ketone was added and dissolved, and this solution was heated to 70°C. To this solution, 10 parts of 30% aqueous solution of sodium hydroxide was added with stirring and a reaction was effected for an hour. Then this solution was washed with water three times, and methyl isobutyl ketone was evaporated at 180°C under a reduced pressure by using a rotary evaporator to obtain 212 parts of liquid epoxy resin A represented by the following formula (1). The epoxy equivalent of thus obtained epoxy resin was 238 g/eq, and the viscosity of the resin at 25°C was 113400 mPa·s.

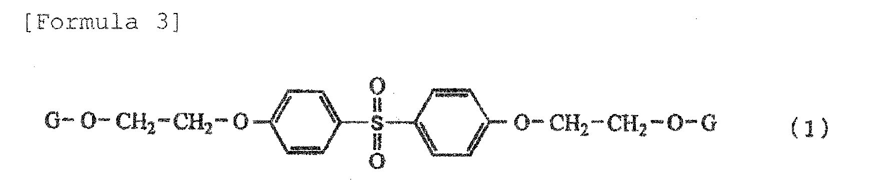

In the formula (1), G represents a glycidyl group.

### Synthesis Example 2: Synthesis of ethylene oxide addition bisphenol fluorene epoxy resin (epoxy resin B)

In a flask equipped with a thermometer, a dropping funnel, a condenser, and a stirrer, under nitrogen gas purge, 220 parts of BPEF (a tradename for bisphenoxyethanol fluorene manufactured by OSAKA GAS CO., LTD., white solid, and melting point: 124 to 126) were dissolved in 370 parts of epichlorohydrin, and 5 parts of tetramethylammonium chloride was added thereto. This solution was heated to 45°C, and 60 parts of flake form sodium hydroxide were separately added thereto over 100 minutes; subsequently a reaction was further effected at 45°C for 3 hours. After the reaction was complete, the solution was washed with water twice to remove generated salts. After that, excessive epichlorohydrin and the like were evaporated with heating to 130°C under a reduced pressure by using a rotary evaporator. To thus obtained residue, 552 parts of methyl isobutyl ketone were added and dissolved. This methyl ethyl ketone solution was heated to 70°C. To this solution, 10 parts of 30% aqueous solution by weight of sodium hydroxide were added, and a reaction was effected for an hour. Then this solution was washed with water until the pH of a cleaning solution became neutral. Subsequently, a water layer was separated and removed. Methyl ethyl ketone was evaporated with heating under a reduced pressure from an oil layer by using a rotary evaporator to obtain epoxy resin B represented by the following formula (2). Thus obtained epoxy resin was semisolid and the epoxy equivalent of the resin was 294 g/eq.

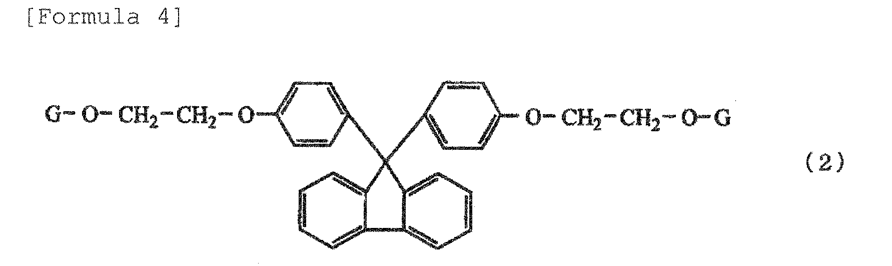

In the formula (2), G represents a glycidyl group.

### Example 1

Bisphenol F epoxy acrylate was obtained by reaction of RE-404P (a tradename for bisphenol F type epoxy resin manufactured by Nippon Kayaku Co., Ltd., epoxy equivalent: 160 g/eq, and hydrolyzable chlorine amount: 30 ppm) with 100% equivalent of acrylic acid based on an epoxy group; purification by a separating treatment with ion exchanged water/toluene; and subsequent evaporation of toluene. A resin solution was obtained by heating at 90°C and dissolving 80 parts by weight of thus obtained bisphenol F epoxy acrylate, 20 parts by weight of epoxy resin A in Synthesis Example 1, as radical formation photo polymerization initiators, 1.8 parts by weight of ADEKA OPTOMER-N-1414 (a tradename for 3,6-bis (2-methyl-2-morphorinopropionyl)-9-n-octylcarbazole manufactured by Asahi Denka Co., Ltd.), and 1.2 parts by weight of KBM-603 (a tradename for an aminosilane coupling agent N-β(aminoethyl)γ-aminopropyltrimethoxysilane manufactured by Shin-Etsu Silicones). To this resin solution cooled to room temperature, 4.1 parts by weight of IDH-S (a tradename for isophthalic acid dihydrazide manufactured by OTSUKA Chemical Co., Ltd., melting point: 224°C, active hydrogen equivalent: 48.5 g/eq, average particle diameter: 1.7 µm, and maximum particle diameter: 7 µm) obtained by pulverizing jet milled grade IDH-S by using a jet mill, 30 parts by weight of CRYSTALITE 1FF (a tradename for molten crushed silica manufactured by TATSUMORI LTD., and average particle diameter: 1.0 µm), and 1 part by weight of IXE-100 (a tradename for a zirconium phosphate based ion catcher manufactured by TOAGOSEI CO., LTD.) were added, and this solution was kneaded by using a triple roll mill to obtain a sealant (1) for a photoelectric conversion device according to the present invention. The viscosity of the sealant at 25°C was 300 Pa·s, which was measured by using an R type viscometer RU manufactured by TOKI SANGYO CO., LTD.).

### Example 2

Bisphenol F epoxy acrylate was obtained by reaction of the RE-404P with 100% equivalent of acrylic acid based on an epoxy group; purification by a separating treatment with ion exchanged water/toluene; and subsequent evaporation of toluene. A resin solution was obtained by heating at 90°C and dissolving 80 parts by weight of thus obtained bisphenol F epoxy acrylate, 20 parts by weight of epoxy resin B in Synthesis Example 2, as radical formation photo polymerization initiators, 1.8 parts by weight of the ADEKA OPTOMER-N-1414, and 1.2 parts by weight of the KBM-603. To this resin solution cooled to room temperature, 3.3 parts by weight of the IDH-S pulverized by using a jet mill, 30 parts by weight of the CRYSTALITE 1FF, and 1 part by weight of the IXE-100 were added, and this solution was kneaded by using a triple roll mill to obtain a sealant (2) for a photoelectric conversion device according to the present invention. The viscosity of the sealant at 25°C was 400 Pa·s, which was measured by using the R type viscometer.

### Evaluation test 1

Next, each of the sealants obtained in Examples 1 and 2 was evaluated by determining adhesion strength, pot life, glass transition temperature, and the amount of the sealant component leaching to a charge transfer layer. The results are shown in Table 1.

### [Table 1]

**Table 1**

| | Example 1 | Example 2 |
|---|---|---|
| Adhesion strength (MPa) | 75 | 75 |
| Pot life (viscosity increase %) | 20 | 20 |
| Glass transition temperature (°C) of cured compound | 87 | 87 |

| Test of contamination of charge transfer layer | | |
|---|---|---|
| Total of leaching amount (ppm) | 500 | 650 |
| Epoxy resin A | 50 | - |
| Epoxy resin B | - | 200 |
| Bisphenol F type epoxy diacrylate | 450 | 450 |
| Isophthalic acid dihydrazide (IDH) | ND | ND |

In Table 1, ND represents levels below the limits of detection. Example 1 does not contain epoxy resin B, and - is indicated in the corresponding part. Example 2 does not contain epoxy resin A, and - is indicated in the corresponding part.

As is evident from Table 1, the sealants according to the present invention obtained in Examples 1 and 2 have excellent properties such as adhesion strength, pot life, glass transition temperature, and leaching amount. That is, it has been established that the sealants according to the present invention exhibit considerably reduced leaching amount to charge transfer layers while the properties as sealants are maintained. The tests were conducted by the following methods, respectively.

### Adhesion strength

To 100 g of each of the sealants, 1 g of 5 µm glass fiber was added as a spacer and mixed with stirring. This sealant was applied to a 50 mm × 50 mm glass substrate. Onto the sealant, 1.5 mm × 1.5 mm glass piece was placed. Ultraviolet rays were irradiated at 3000 mJ/cm² to the compound by using an ultraviolet irradiation apparatus, and the compound was cured in an oven at 120°C for an hour. The shear bonding strength of the glass piece was determined.

### Pot life

Each of the sealants was left at 30°C, and then viscosity increase rate (%) of the sealant was determined after a lapse of 48 hours based on the initial viscosity.

### Glass transition temperature

Each of the sealants was interposed between polyethylene terephthalate (PET) films to obtain a thin film of the compound with a thickness of 60 µm. Ultraviolet rays were irradiated at 3000 mJ/cm² to the thin film by using an ultraviolet irradiation apparatus, and the film was cured in an oven at 120°C for an hour. After the curing was complete, PET films were stripped from the thin film to obtain a sample. TMA test was conducted by using an apparatus manufactured by ULVAC-RIKO, Inc., and then glass transition temperature was determined in tension mode.

### Test of contamination of charge transfer layer

The components of the sealants that leached to a charge transfer layer due to the contact between the layer and each of the uncured sealants were determined by gas chromatography. 0.1 g of the sealant was placed in a sample vessel, and 1 ml of the following charge transfer layer (E) was added thereto. Then with simulating curing conditions of the sealant, ultraviolet rays were irradiated at 3000 mJ/cm² to the sealant by using an ultraviolet irradiation apparatus, and the compound was subjected to a curing contact treatment in an oven at 120°C for an hour. After that, the compound was left at room temperature for an hour, and then the charge transfer layer after the contact treatment was transferred to an empty sample vessel. The components of the sealant that leached to this charge transfer layer (E) were determined by gas chromatography with using pentadecane as an internal standard substance.

Composition of charge transfer layer (E) : 0.5 M of DMPII (1,2-dimethyl-3-propylimidazolium iodide), 0.05 M of I₂ (iodine), and 1.0 M of TBP (t-butylpyridine) were dissolved in EMI (1-ethyl-3-methylimidazolium)-TFSI

### (bistrifluoromethanesulfonylimide).

### Example 3

As shown in the example of a photoelectric conversion device (Fig. 1), a semiconductor electrode 1 was prepared by applying paste of TiO₂ particles (P25 manufactured by Degussa Co., Ltd.) as a semiconductor containing layer to the conductive surface of a FTO conductive glass support as a conductive support; firing the substrate at 450°C for 30 minutes; and immersing the substrate into 3 × 10⁻⁴ M solution of a dye represented by a formula (3) in ethanol for 24 hours. After that, a counter electrode was prepared by depositing Pt at a thickness of 200 angstroms also on the conductive surface of a FTO conductive glass support.

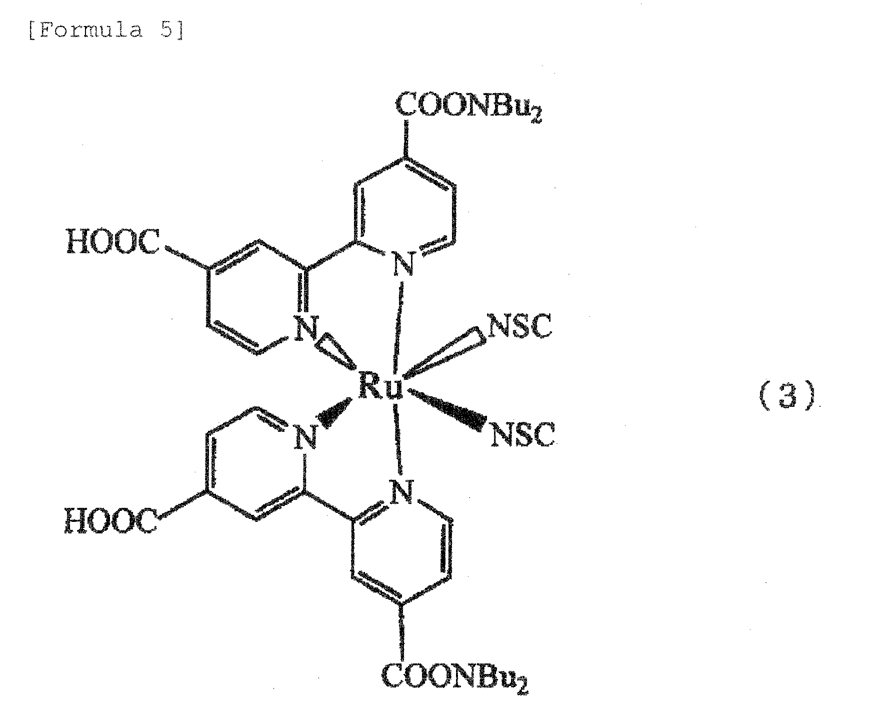

Then the sealant (1) 5 obtained in Example 1 was applied on the periphery of the counter electrode 3 with remaining a hole for injecting a charge transfer layer 4 by using a dispenser, and the semiconductor electrode 1 was overlaid on the counter electrode 3. After the overlaying, a gap was formed by pressing, and UV rays were irradiated at 3000 mJ to provisionally bond the electrodes. Then the electrodes were heated in an oven at 120°C for an hour to cure the sealant to bond the electrodes.

Next, an iodine-based charge transfer layer (b) (iodine/lithium iodide/methylhexylimidazolium iodide manufactured by SHIKOKU CHEMICALS CORPORATION/t-butylpyridine were dissolved in 3-methoxypropionitrile so that the composition of thereof became 0.1 M/0.1 M/0.6 M/1- M) was filled in the cell from the hole for injecting a charge transfer layer of the bonded electrodes, and the injection hole was sealed with an epoxy resin, thereby providing a photoelectric conversion device (cell 1) according to the present invention.

### Example 4

A photoelectric conversion device (cell 2) according to the present invention was obtained as with Example 3 except that the sealant (2) for a photoelectric conversion device in Example 2 was used, and a semiconductor containing layer prepared by hydrolyzing titanium alkoxide by sol-gel method was used according to Non-Patent Document 1.

### Example 5

A photoelectric conversion device (cell 3) according to the present invention was obtained in Example 3 where a weir was formed on the periphery of a conductive support having a semiconductor containing layer supporting a dye on the support as with Example 1 by using the sealant (1) prepared in Example 1, and a charge transfer layer (a) was dropped in the weir in an amount so that a 30 µ gap would be formed; a counter electrode was overlaid on the support under a reduced pressure; then a gap was formed by pressing, and UV rays were irradiated at 3000 mJ to provisionally bond the support and the electrode; and then they were heated in an oven at 120°C for an hour to cure the sealant.

### Example 6

A photoelectric conversion device (cell 4) according to the present invention was obtained as with Example 3 except that the dye represented by the formula (3) was replaced with a dye represented by the following formula (4).

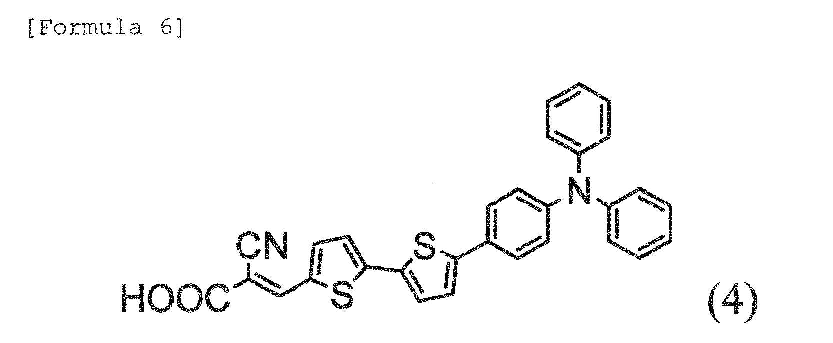

### Example 7

A photoelectric conversion device (cell 5) according to the present invention was obtained as with Example 3 except that the dye represented by the formula (3) was replaced with a dye represented by the following formula (5).

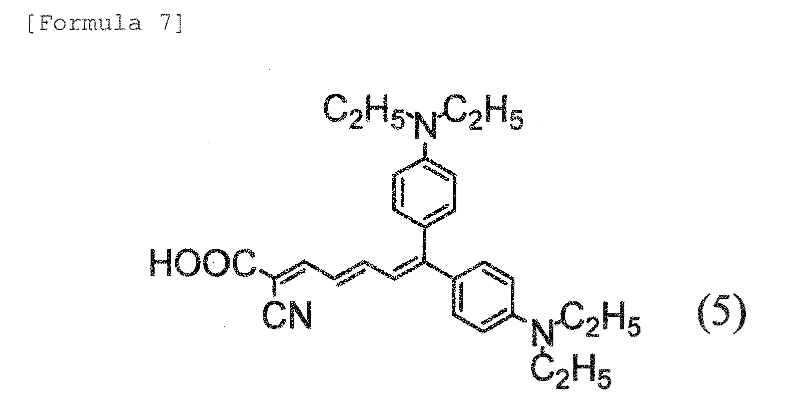

### Example 8

A photoelectric conversion device (cell 6) according to the present invention was obtained as with Example 3 except that the dye represented by the formula (3) was replaced with a dye represented by the following formula (6).

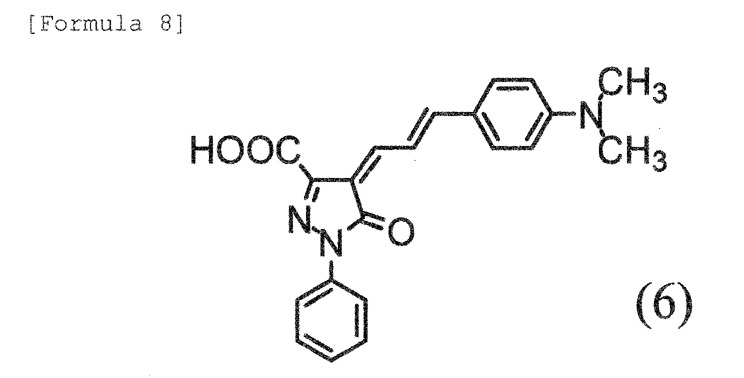

### Example 9

A photoelectric conversion device (cell 7) according to the present invention was obtained as with Example 3 except that the dye represented by the formula (3) was replaced with a dye represented by the following formula (7).

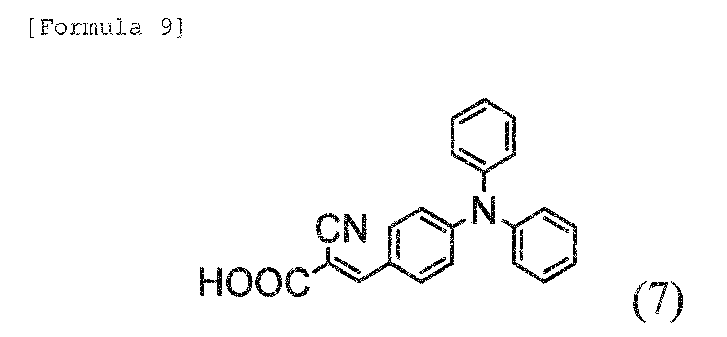

### Comparative Example

A cell of Comparative Example was obtained as with Example 3 except that commercial HIMILAN (manufactured by DU PONT-MITSUI- POLYCHEMICALS CO., LTD.) was used as the sealant.

### Evaluation test 2

### Photoelectric conversion efficiency measurement

Solar cells according to the present invention were obtained by connecting lead wires to the both electrodes of each of the obtained photoelectric conversion devices and placing a voltmeter and an ammeter. The photoelectric conversion efficiency of each of the solar cells was measured. The measurement size of each photoelectric conversion device was 0.5 × 0.5 cm². As for a light source, a 1 kW xenon lamp (manufactured by WACOM) was used through an AM 1.5 filter to be at 100 mW/cm². Short circuit current, open circuit voltage, and photoelectric conversion efficiency were measured by using a solar simulator (WXS-155S-10 manufactured by WACOM).

### [Table 2]

**Table 2**

| | Short circuit current (mA/cm²) | Open circuit voltage (V) | Photoelectric conversion efficiency (%) |
|---|---|---|---|
| Cell 1 | 14.6 | 0.72 | 6.5 |
| Cell 2 | 13.5 | 0.68 | 5.9 |
| Cell 3 | 14.4 | 0.70 | 6.4 |
| Cell 4 | 14.6 | 0.70 | 5.8 |
| Cell 5 | 15.1 | 0.64 | 6.1 |
| Cell 6 | 12.1 | 0.59 | 4.8 |
| Cell 7 | 10.6 | 0.73 | 5.2 |

### Evaluation test 3

### Durability test

The solar cells (cells 1 to 6) used in the Evaluation test 2 were tested as to durability. Cells 1 to 6 were in operation for a time period of 180 days at a constant temperature (25°C). Photoelectric conversion efficiency (%) of each cell was determined at the initial stage, after a lapse of 30 to 180 days. The results are shown in Table 3.
As is evident from Table 3, the conversion efficiency of each cell did not decrease considerably at any measurement time, and all the cells exhibited excellent durability. The cells using an organic dye represented by (4), (5), (6), or (7) as a sensitizing agent instead of the metal complex dye (3) also exhibited good durability. In contrast, as to the Comparative Example cell using the commercial sealant, its conversion efficiency was almost halved after a lapse of 30 days, and decreased to about one sixth of the initial efficiency after a lapse of 180 days .

### [Table 3]

**Table 3**

| | Initial value | After a lapse of 30 days | After a lapse of 60 days | After a lapse of 120 days | After a lapse of 180 days |
|---|---|---|---|---|---|
| Cell 1 | 6.5 | 6.3 | 6.2 | 6.6 | 6.4 |
| Cell 2 | 5.9 | 5.8 | 5.5 | 5.7 | 5.8 |
| Cell 3 | 6.4 | 6.4 | 6.3 | 6.5 | 6.3 |
| Cell 4 | 5.8 | 5.9 | 5.8 | 6.0 | 6.1 |
| Cell 5 | 6.1 | 6.1 | 6.1 | 5.9 | 5.8 |
| Cell 6 | 4.8 | 4.8 | 4.7 | 4.6 | 4.6 |
| Cell 7 | 5.2 | 5.3 | 5.3 | 5.3 | 5.3 |
| Comparative Example | 6.4 | 3.8 | 1.9 | 1.9 | 1.0 |

### BRIEF DESCRIPTION OF THE DRAWINGS

Fig. 1 is a schematic section view of the main structure of a photoelectric conversion device according to the present invention.

### DESCRIPTION OF SYMBOLS

- 1: denotes a conductive support
- 2: semiconductor containing layer (1 and 2 constitute an anode)
- 3: counter electrode (a cathode)
- 4: charge transfer layer
- 5: sealant
- 6: denotes a glass substrate

## Claims

1. A sealant for a photoelectric conversion device, **characterized by** comprising (a) an epoxy resin, (b) a heat curing agent, (c) epoxy (meth) acrylate, and (d) a photopolymerization initiator.

2. The sealant for a photoelectric conversion device according to claim 1, wherein the heat curing agent (b) is at least one agent selected from the group consisting of hydrazides, amines, acid anhydrides, imidazoles, and polyhydric phenols.

3. The sealant for a photoelectric conversion device according to claim 1 or 2, wherein the epoxy (meth)acrylate (c) is bisphenol A type epoxy (meth) acrylate, novolac type epoxy (meth) acrylate, or resorcin (meth)acrylate.

4. The sealant for a photoelectric conversion device according to any one of claims 1 to 3, wherein the photopolymerization initiator (d) is at least one initiator selected from the group consisting of acetophenone based, benzoin based, benzophenone based, thioxanthone based, carbazole based, anthraquinone based, acylphosphine based, and acridine based photopolymerization initiators.

5. The sealant for a photoelectric conversion device according to any one of claims 1 to 4, further comprising (e) a filler.

6. The sealant for a photoelectric conversion device according to claim 5, wherein the filler (e) is at least one filler selected from the group consisting of hydrous magnesium silicate, calcium carbonate, aluminum oxide, crystalline silica and molten silica; and said at least one filler has an average particle diameter equal to or less than 3 µm.

7. The sealant for a photoelectric conversion device according to any one of claims 1, to 6, further comprising (f) a silane coupling agent.

8. The sealant for a photoelectric conversion device according to claim 7, wherein the silane coupling agent (f) is selected from glycidyl ethoxysilanes and glycidyl methoxysilanes.

9. The sealant for a photoelectric conversion device according to any one of claims 1 to 8, further comprising (g) an ion catcher.

10. The sealant for a photoelectric conversion device according to claim 9, wherein the ion catcher (g) is at least one catcher selected from the group consisting of bismuth oxide based, antimony oxide based, titanium phosphate based, zirconium phosphate based, and hydrotalcite based ion catchers.

11. A photoelectric conversion device wherein a first conductive support comprising a semiconductor containing layer and a second conductive support comprising a counter electrode are placed so that the supports face each other with a predetermined spacing; a charge transfer layer is interposed in a gap between the supports; and seal is provided on the periphery of the supports by using the sealant for a photoelectric conversion device according to any one of claims 1 to 10.

12. A solar cell comprising the photoelectric conversion device according to claim 11.

13. The solar cell according to claim 12, **characterized by** comprising at least one sensitizing agent selected from the following compounds (3), (4), (5), (6), and (7).
